Europäisches Patentamt

European Patent Office

Office européen des brevets

(11) Publication number: **0 221 429**
**A2**

## (12) EUROPEAN PATENT APPLICATION

(21) Application number: **86114517.5**

(22) Date of filing: **20.10.86**

(51) Int. Cl.⁴: **C23C 16/44** , **H01L 21/205**

(30) Priority: **08.11.85 US 796675**

(43) Date of publication of application:
**13.05.87 Bulletin 87/20**

(84) Designated Contracting States:
**CH DE FR GB IT LI NL SE**

(71) Applicant: **Focus Semiconductor Systems, Inc.**
**570 Maude Court**
**Sunnyvale California 94086(US)**

(72) Inventor: **Mahawili, Imad**
**570 Maude Court**
**Sunnyvale California 94086(US)**

(74) Representative: **Frankland, Nigel Howard et al**
**FORRESTER & BOEHMERT**
**Widenmayerstrasse 4/I**
**D-8000 München 22(DE)**

(54) Chemical vapour deposition reactor.

(57) A film of a selected thickness profile is deposited on to a wafer by locating the wafer in a chamber and introducing one or more gases into the chamber to effect the deposition. A region is created within the chamber adjacent the wafer, the region having a configuration determined in accordance with the desired thickness profile of the film to be deposited. The film may be uniform or non-uniform.

FIG. I

EP 0 221 429 A2

## Chemical Vapour Deposition Reactor

THIS INVENTION relates to a device for performing chemical vapour deposition (CVD) on a substrate and in particular to a CVD reactor and gas injector system for achieving deposition of films having uniform thickness on a semiconductor wafer.

Chemical vapour deposition reactors for processing semiconductor wafers are well known in the art. For example, U.S.-A-4,105,810 shows in Figures 3a, 3b and 3c three configurations of reactors and nozzles for performing chemical vapour deposition on a semiconductor substrate. None of these reactors or nozzle designs completely solves the problem of depositing a coating on a wafer so that the coating has a uniform thickness. In fact, the problem of achieving a coating of uniform thickness over the entire surface of a wafer has become more acute and more difficult as semiconductor wafers have increased in size (diameter). In turn, the proposed solutions to the problem have become more complex. For example, with a view to improving uniformity, U.S.-A-4,105,810 states that it is preferred to impart a rotational or reciprocating movement to the nozzle within the reaction chamber or to the substrate. However, in addition to introducing problems of reliability, such moving parts themselves tend to introduce undesirable particulate contamination without in fact solving the problem of uniform deposition.

According to one aspect of this invention there is provided a method of depositing a film of a selected thickness profile onto a wafer, said method comprising the steps of locating the wafer in a chamber, and introducing one or more gasses to the chamber to effect said film deposition, characterised in that the method comprises the preliminary step of creating a region within the chamber adjacent the wafer, the region having a configuration determined in accordance with the desired thickness profile of the film.

Preferably the method further comprises the steps of locating a plurality of wafers in said chamber and introducing said one or more gases to the chamber to deposit a film of a selected thickness profile onto each wafer, the method also comprising the step of locating a plurality of plates in the chamber, each plate having a surface facing a surface of a respective one of said plurality of wafers, the shape of the region defined between each plate and the respective wafer having a configuration determined in accordance with the desired thickness profile of the film to be deposited on the respective wafer.

According to another aspect of this invention there is provided an apparatus for depositing film of a selected thickness profile on to a wafer, said apparatus comprising means defining a chamber, means for locating said wafer within the chamber with at least one face of the wafer exposed, and means for introducing one or more gases to the chamber to effect film deposition, characterised in that means are provided within the chamber to define a region adjacent the or each exposed face of the wafer, the region having a configuration such that the distance between the exposed face of the wafer and the surface opposed to the exposed face of the wafer which defines said region is not uniform over the whole face of the wafer.

Preferably, in use, the film is deposited with a non-uniform profile, the profile being controlled at least partly by said configuration.

Conveniently the means defining said region comprise means defining a right circular conical region, which may extend towards the wafer, or away from the wafer.

Preferably the said surface opposed to the exposed face of the wafer comprises an annular region of predetermined configuration, different from the configuration of the rest of the surface, to suppress edge effects.

Conveniently the means defining the conical region define a substantially flat annular region surrounding the conical region to suppress edge effects.

Advantageously means are provided to heat said substrate to a selected temperature.

Preferably said chamber is a cylindrical chamber, said chamber having a base defining a well which constitutes the means for locating the wafer in the chamber.

Conveniently said base supports said wafer in a substantially vertical orientation.

Preferably an annular exhaust vent is provided surrounding said base to exhaust gas from said chamber.

Conveniently the means for introducing gases to the chamber comprises a plurality of jets, and means to inject one or more gases through the jets into the chamber, each jet being provided with means to deflect gas from the jet towards a peripheral wall of said chamber.

Preferably means are provided to hold a plurality of wafers in position within the chamber.

Advantageously means are provided to locate a plurality of plates in said chamber to constitute said region defining means, each plate having a surface facing a surface of a respective one of said plurality of wafers and defining a respective said region therebetween.

According to a further aspect of this invention there is provided an apparatus for depositing a film onto a wafer, said apparatus comprising a chamber and means for locating said wafer within the chamber with at least one face of said wafer exposed, said chamber including a first wall opposite said wafer, characterised in that said apparatus further comprises a first plurality of nozzles located near the periphery of said first wall for introducing a first gas into said chamber, said first plurality of nozzles directing said first gas away from the center of said chamber; and first means for deflecting said first gas towards the center of said chamber.

Preferably said apparatus further comprises a second plurality of nozzles located near the periphery of said first wall for introducing a second gas into said chamber, said second plurality of nozzles directing said second gas away from the center of said chamber; and second means for deflecting said second gas towards the center of said chamber.

Conveniently the apparatus further comprises an annular exhaust vent laterally surrounding said wafer, said gas or gases exiting said chamber via said exhaust vent.

A preferred embodiment of the invention comprises a CVD reactor having a unique geometry which enables chemical vapor deposited film having a controlled thickness to be formed on the surface of a substrate. The reactor chamber is approximately cylindrical in shape. A substrate, typically a semiconductor wafer, is positioned on a heater platform which forms a portion of the base of the approximately cylindrical reactor chamber. In one preferred embodiment the base of the reactor chamber is circular and the surface of the base on which the wafer is place is inclined at an angle of approximately 3-5° from the vertical (i.e. the direction of the earth's gravity vector). In this embodiment, the heater platform has a slightly recessed circular well for holding the semiconductor wafer.

The slight incline enables the force of gravity to hold the semiconductor wafer in the well while the wafer surface remains approximately vertical - (i.e. within 3-5° of vertical) and, more importantly, the recessed well reduces the edge effects that would be caused by positioning a wafer on a heater platform having a flat surface wherein the raised edge of the wafer interferes with the gas flow across the wafer surface.

The gas injector system for the preferred reactor includes means for introducing one or more gases into the reactor chamber. Each gas enters the reaction chamber from a corresponding gas line and flows into a recessed annular chamber corresponding to that gas line, the recessed annular chamber being located in the top portion of the reactor structure opposite the base of the reactor. Each gas becomes uniformly distributed in its annular chamber and then enters the reactor chamber through a plurality of small orifices that are preferably uniformly distributed along the surface of the annular chamber. Each gas is deflected outward toward a circular wall connecting the base and the top of the reactor chamber by a corresponding annular deflection plate appropriately positioned with respect to the corresponding plurality of orifices. The injected gases thus become uniformly mixed in the peripheral region of the reactor chamber adjacent the circular wall and the gaseous mixture then flows radially inward toward the central region of the reactor.

The reactor gases exit from the reactor chamber of the preferred embodiment via an annular vent surrounding the heater platform, passing into a vent chamber laterally surrounding the heater platform. This vent chamber is connected to a vacuum pump.

Of importance, the rate of deposition of the film at each point on the wafer is controlled geometrically by appropriately configuring the inner top surface of the reactor chamber. In one embodiment this is done by using what is called a "Z plate". The Z plate is a plate that specifies the distance between each point on the surface of the heater platform (and hence the wafer) and the corresponding point directly opposite it on the Z plate. In general, by appropriately configuring the Z plate, a film having a desired thickness profile is produced on the substrate. In one embodiment, by appropriately configuring the Z plate, the edge effects, which still exist despite the recessed well for holding the wafer, are suppressed and a CVD coating having a controlled thickness in each region of the wafer is produced. Typically the Z plate is configured in order to produce a CVD coating having a uniform thickness over the entire surface of the wafer. The preferred shape of the Z plate for producing a uniform thickness depends on the diameter of the wafer and the diameter of the cylindrical reactor chamber. Using this geometric control technique, wafers having a chemical vapor deposited film having a uniform thickness of $T \pm 1\%T$ have been repeatedly produced. For many reactions the uniformity is $T \pm 0.7\%T$. If desired, the Z plate may be configured to produce films having other depth profiles, for example, films which are relatively thicker near the centre of the wafer or alternatively, films which are relatively thicker near the edge of the wafer. However, typically the Z plate is designed in order to produced a highly uniform film over the entire surface of the wafer.

In order that the invention may be more readily understood and so that further features thereof may be appreciated the invention will now be described by way of example with reference to the accompanying drawings, in which:

FIGURE 1 shows a cross section of one embodiment of a gas injection and CVD reactor system in accordance with the present invention;

FIGURE 2 shows a partial cross section of one embodiment of the fluidized bed heater shown in Figure 1;

FIGURE 3 shows a front view of the wafer platform mounted on the front surface of the heater shown in Figure 2;

FIGURE 4 shows a front view cross section of the heater shown in side view cross section in Figures 1 and 2;

FIGURE 5 shows a view of the injector section of Figure 1 as viewed from the heater section of Figure 1;

FIGURE 6 shows the gas injector plate and gas jets therein,

FIGURES 7a, 7B and 7c show three typical Z plate geometries in cross section; and

Figure 8 shows an embodiment of the invention for a diffusion tube.

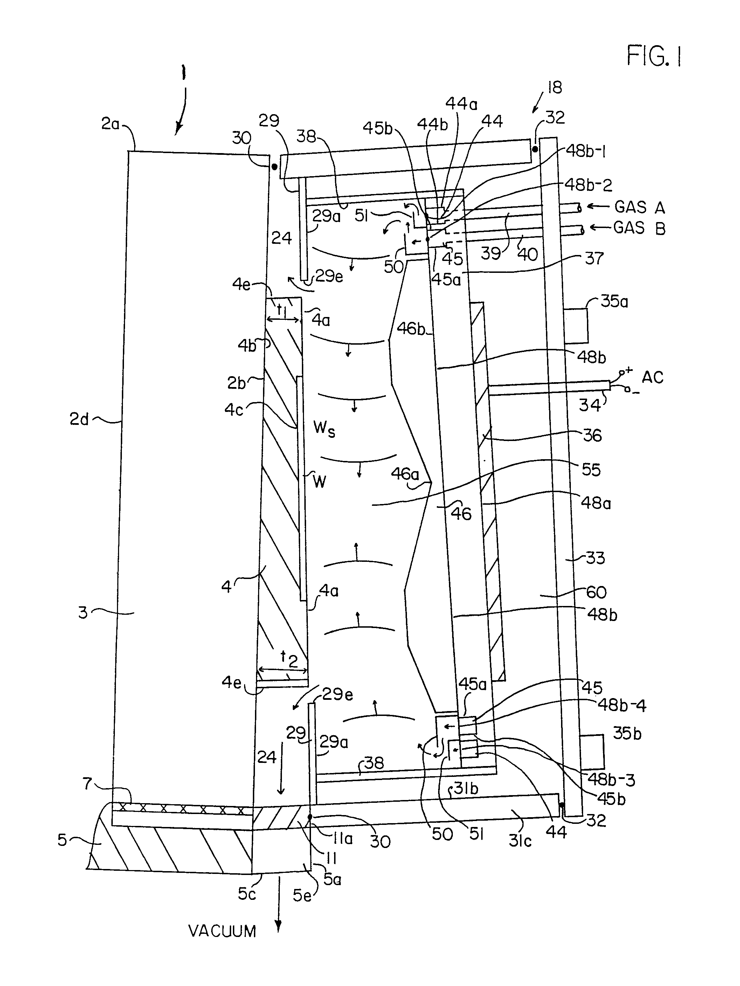

Figure 1 shows a cross section of one preferred embodiment of the gas injection and CVD reactor system of the present invention. The system includes a heater section 1 and a gas distribution section 18 which together form reactor chamber 55 when joined together by elastomeric O-ring 30.

In a preferred embodiment, heater section 1 comprises a fluidized bed heater. The preferred heater is described below. However, other heaters known in the art, for example resistive heaters, radiant heaters or radio frequency coupled heaters may be used with the present invention.

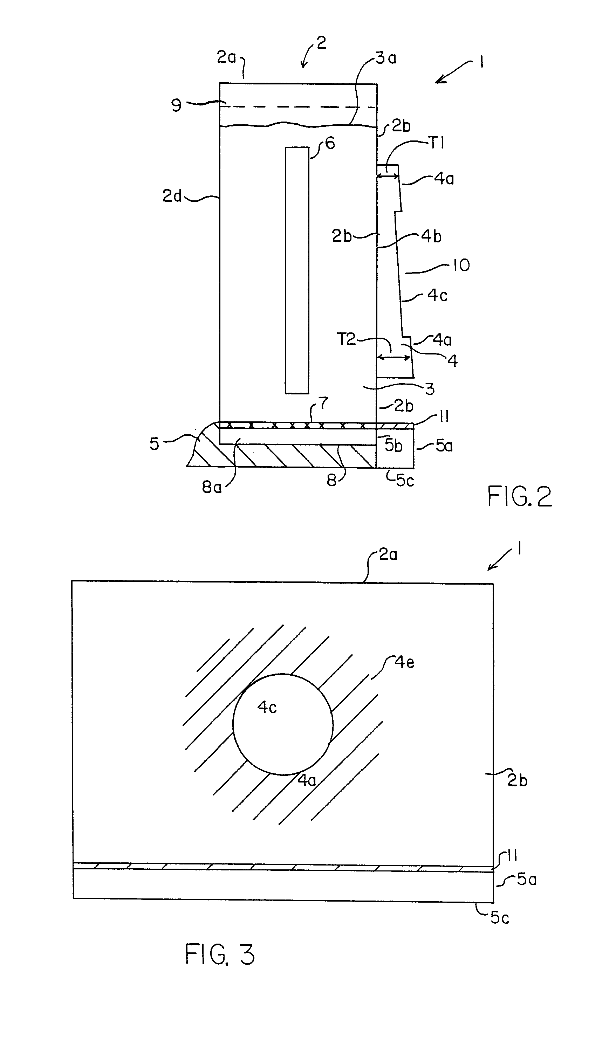

FIGURE 2 shows a partial cross section of one preferred embodiment of fluidized bed heater 1. A heater mantle or housing 2 comprising top surface 2a, planar front surface 2b and planar rear surface 2d has a generally rectangular cross-sectional shape. The mantle 2 is rigidly attached to a bottom support plate 8 in a base 5. The heater mantle 2 may be made out of a variety of materials, for example, metal, silicon, quartz, or graphite. The back surface 4b of a wafer holding platform 4 is attached to the front rectangular surface 2b of the mantle 2. Platform 4 is a circular platform having a thickness $T_1$ at the top of the platform as indicated by arrow $T_1$ in Figure 2 and having a thickness $T_2$ greater than $T_1$ at the bottom of the platform as

indicated by arrow $T_2$ in Figure 2. The platform has a peripheral edge 4e. As shown in Figure 2 and Figure 3, the circular front surface 4a of platform 4 has a uniformly recessed circular well 10 concentric with the circumference of the platform 4 for holding a semiconductor wafer W. Figure 3 shows a front view of the wafer platform 4 mounted on the front rectangular surface 2b of the heater 1. The surface 4c which forms the bottom of the wall 10 is recessed relatively to surface 4a which forms the front of the platform 4. A semiconductor wafer (substrate) W may be positioned in the well 10 of the heater platform 4 as shown in Figure 1. The depth of the well 10 is about 0.010 inches (0.25 mm) greater than the nominal thickness of the wafer W so that the front surface $W_S$ of the wafer W does not protrude above the surface 4a even for those wafers whose thickness exceeds the nominal thickness by up to 0.010 inches (0.25 mm). The diameter of the well 10 is designed to be approximately 0.02 inches (0.5mm) greater than the diameter of the wafer W.

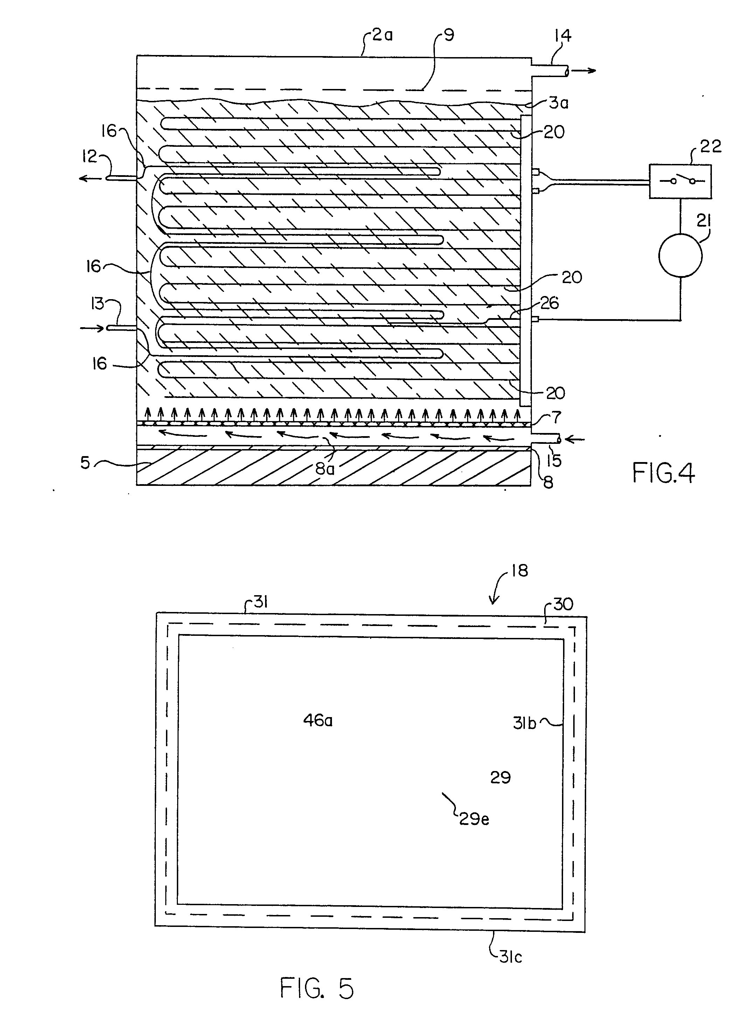

Referring now to Figures 2 and 4, fluidizing gas, typically an inert gas such as nitrogen, is introduced under pressure into a plenum chamber 8a between a bottom support plate 8 and a distribution plate.(diffuser) 7. The gas supply may be connected to the chamber 8a via the base 5 or through a suitable opening (not shown in Figure 2) in the mantle 2 between the support plate 8 and the diffuser 7. The particles which constitute a bed 3 rest upon the distribution plate 7. These particles may be made of a wide variety of materials having a wide range of particle size distribution, for example, metal powders, ceramic balls, or sand. In one embodiment of the heater 40-80 mesh particles of alumina are employed. In another embodiment, 10-200 mesh sand particles are employed though even larger particles may be used.

A mesh screen 9 is located above the top surface 3a of the bed 3 and serves to prevent bed particles escaping from the bed. The mesh of the screen 9 is typically smaller than the mean particle size.

In use the pressurized gas passes upward through bed 3, fluidizing the bed, and then passes through mesh screen 9. The pressurized gas exits the heater by means of an opening 14 (not shown in Figure 2) in the mantle 2 located above the mesh screen 9. A rectangle 6 in Figure 2 shows - schematically the relative location of heating and cooling elements in bed 3. These heating and cooling elements are shown in more detail in Figure 4. A grating 11 and plates 5a, 5b and 5c shown in Figure 2 form a rectangular chamber which is connected to a vacuum pump which evacuates gaseous products formed in a chamber 55 (Figure 1).

Figure 4 shows a front view cross section of the heater which is shown in side view cross section in Figures 1 and 2. In Figure 4 the fluidizing gas enters gas chamber 8a through an opening 15 in the mantle 2 located between the bottom support 8 and the distribution plate 7. The fluidized gas exits from the heater through an opening 14 in the mantle 2 located above the mesh screen 9. The heating and cooling elements shown in Figure 4 are located in the region 6 shown in Figure 2. The cooling elements include a tube 16 through which a liquid e.g. water is circulated when the bed is being cooled. The water enters through an opening 13 in the mantle 2 and exits through an opening 12 in the mantle 2 after flowing through tubular loops indicated schematically by line 16 in Figure 4.

Figure 4 shows the location of wire heating element 20 in the region 6. A thermocouple 26 senses the temperature of the fluidized bed 3 and provides a signal representing the temperature to a controller 21 which controls a power switch 22. When the temperature sensed by the thermocouple 26 reaches a selected temperature $T_1$ the controller 21 causes a switch 22 to stop supplying current to the heating wire 20. When the temperature of the fluidized bed 3 falls below the selected temperature, current is again supplied to the heating wire 20. It is important to note that the selected temperature $T'_1$ to which the fluidized bed is heated is generally higher than the selected temperature $T_1$ to which it is desired to heat the wafer W. This higher temperature is needed in order to allow for the thermal gradient across the heater mantle 2 and across the platform 4 and to allow for heat losses.

Employing this fluidized bed heater and the above described thermocouple, the temperature of the wafer resting in well 10 is maintained at a selected temperature $T_1 \pm 1°C$. This temperature is uniform over the entire surface of the wafer. The cooling tube 16 has sufficient capacity to rapidly cool the bed 9 to a second selected temperature $T_2'$ which corresponds to a second selected temperature $T_2$ for the wafer W. Once the selected temperature is achieved, it is maintained by the controller 21, switch 22 and thermocouple 26. The cooling liquid enters the cooling tube 16 via the opening 13 and exits the fluidized bed via the opening 12.

The heater section 1 described above with reference to Figures 1, 2, 3 and 4 is designed to mate with the gas injector section 18 shown in Figures 1 and 5 thereby forming the reactor chamber 55. Figure 1 shows the gas injector section 18 in cross section and Figure 5 shows the gas injector section 18 as viewed from the heater section 1.

The gas injector section 18 comprises a housing 31 which is a rectangular housing which is joined by elastomeric O-ring 30 to the rectangular perimeter of surface 2b of heater 1 shown in Figure 3 except that lower portion 31c of housing 31 shown in Figure 5 is joined to edge 11a of grating 11 shown in Figure 1 and Figure 3. The housing 31 may be made of various materials, for example, stainless steel. A top plate 33 is provided which is a rectangular plate which is joined to the open side of the rectangular housing 31 by an elastomeric O-ring 32.

An inner, approximately cylindrical, reactor chamber 55 is formed within the housing 31. A rectangular plate 29 extends inwardly from the walls of the housing 31 as shown in Figures 1 and 5. The plate 29 has a central circular section removed to form a hole having an edge 29e of a larger diameter than the diameter of the platform 4 so that an annular opening is created between the edge 29e and platform edge 4e when gas injector section 18 is joined to heater section 1. The housing 31, front heater face 2b, plate 29 and grating 11 together form an exhaust chamber 24 which laterally surrounds the heater platform 4. The exhaust chamber 24 communicates with a vacuum pump - (not shown) via grating 11.

An inner cylindrical housing 38, which in one embodiment is fabricated of aluminium (other metals such as stainless steel or insulating materials may also be employed, the choice depending on the reactant gases and the temperature at which the reaction is carried out), is joined to the plate 29 as shown in Figure 1. This may be accomplished by welding or by machining the plate 29 and the housing 38 as one piece. A circular top plate 37 is joined to the cylindrical housing 38 either by welding or by machining the housing 38 and the top plate 37 as one piece. Thus an approximately cylindrical reactor chamber 55 is defined by the cylindrical housing 38, the circular top plate 37, the plate 29 and the platform 4. Surfaces 29a, 4a and 4c form the circular base of the cylinder, which is inclined at an angle of 3-5° from the vertical.

Reactant gases A and B enter the reactor chamber 55 via gas lines 39 and 40. Each gas line is selected to be large enough so that gas can flow through the line with virtually no resistance. Typically, gas lines 39 and 40 have a diameter of one quarter inch (6.44 mm). Gas line 39 and gas line 40 each pass through a suitable opening in the circular plate 33. The gas line 39 and the gas line 40 communicate with annular chambers 44 and 45, respectively, which are recessed into the top plate 37 of the reactor chamber 55. The width of each recessed chamber (the distance between chamber edge 44a and 44b and the distance between chamber edge 45a and 45b) should be at least one half inch (1.27 cms) and the depth of each chamber should be at least one half inch (1.27 cms). A first reactant gas A is uniformly distributed in annular chamber 44 and a second reactant gas B is uniformly distributed in annular chamber 45.

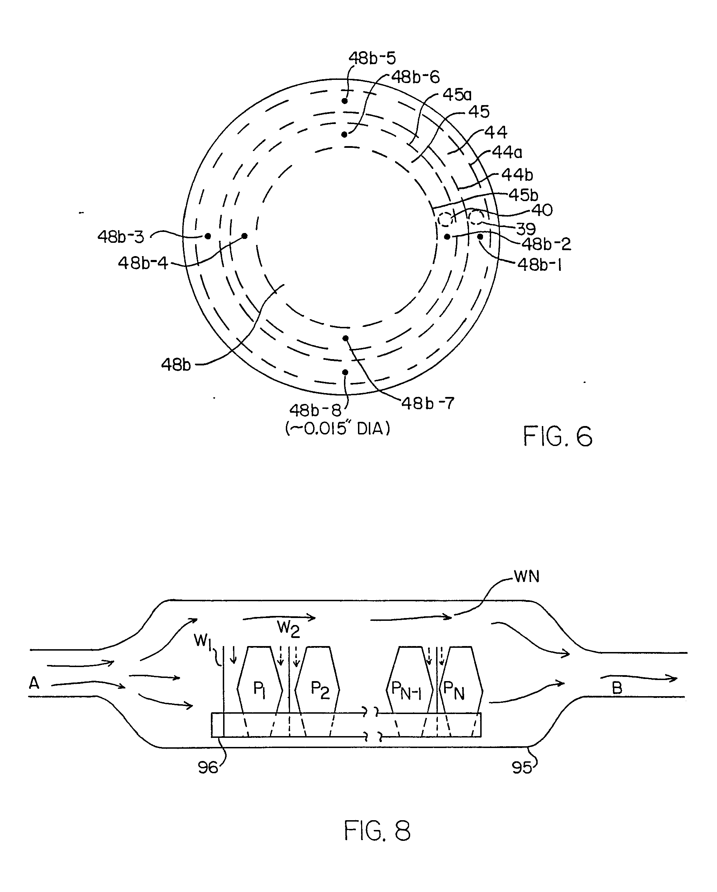

As shown in Figures 1 and 6, gas is communicated from the annular chamber 44 to reactor chamber 55 via orifices (jets) 48b-1, 48b-3, 48b-5, and 48b-7, which are uniformly spaced (90° apart) around the injector plate 48b which forms one side of the annular chamber 44. If desired, a larger number of jets can be employed. Similarly, gas is communicated from the annular chamber 45 to reactor chamber 55 via orifices (jets) 48b-2, 48b-4, 48b-6, and 48b-8 which are uniformly spaced around the injector plate 48b which also forms one surface of annular chamber 45. The jets described above typically have a selected diameter between 0.010 and 0.015 inches (0.25 mm and 0.38 mm) depending on the gas composition and flow rate. The injector plate 48b is attached to the inner surface of the top-plate 37.

L-shaped annular deflector plates 50 and 51 extend from injector plate 48b so that gas emerging from each of the jets 48b-1, 48b-3, 48b-5 and 48b-7 strikes a deflector plate 51 and is deflected radially outward to the cylindrical wall 38. Similarly, gas emerging from each of the jets 48b-2, 48b-4, 48b-6 and 48b-8 strikes a deflector plate 50 and is deflected outward toward the cylindrical wall 38. The provision of the separate deflectors reduces jet velocities of each gas stream prior to mixing of the gases. This prevents the premature reaction of gas A and gas B as a result of high velocity impingement of gas A with gas B during injection. The reactant gases A and B become uniformly mixed in the peripheral region of the reactor chamber adjacent circular cylindrical housing 38 and then flow radially inward as in a dynamically converging toroid toward the central region of the cylindrical chamber.

It has been deduced that as long as the flow is laminar, the Navier-Stokes equation suggests that the motion of the gaseous mixture directed radially inward from inner housing 38 can best be described by the parabolic velocity profiles depicted in Figure 1. These velocity profiles form very near the outer circumference of chamber 55 and proceed across the entire circular perimeter of the wafer and across the surface of the wafer toward the central region of the chamber as in a dynamically converging toroid. The gas molecules moving toward the central region from all radial directions create a slightly higher pressure zone in the center of chamber 55, which subsequently drives gas molecules out of chamber 55, by concentration displacement, through the annular opening formed between the edge 29e of the plate 29 and the edge 4e of the platform 4 into the exhaust chamber 24 which is connected to a vacuum pump (not shown) via grating 11 which connects exhaust chamber 24 to the vacuum exhaust chamber 5e formed by the grating 11, base 5, rectangular plate 5a and plate 5c which has openings (not shown) not connecting to a vacuum pump.

For certain reactions it is desirable to maintain the surface temperature of the inner housing 38 and plate 48b at only a moderately lower level than the heating platform 4. In this case, insulating material is placed in a cavity 60 formed by the outer housing 31, inner housing 38, the outer portion of plate 29, top plate 33 and plate 37. The cavity 60 may also be filled with liquid, e.g. chilled water, which enters cavity 60 via a portion 35a and is recirculated to an external chiller (not shown) via a portion 35b. For still other reactions it is desirable to maintain the plate 37 at a specific temperature higher than that which is achievable using only insulation. For these reactions a separate electric heater 36 is affixed to plate 37 and current supplied via a cable 34 which passes through the top plate 33.

The gas injector system described above has been used experimentally to grow a silicon dioxide film on a silicon wafer. Gas A was silane and gas B was oxygen. Wafer W was maintained by the heater 1 at a temperature of 400°C. Pressure in the reactor chamber 55 was maintained at a selected pressure between 100 and 400 millitorr. Under these conditions it was found that for an eight inch (20.32cms) wafers the depth of the film grown on wafer surface $W_S$ increased monotonically from the edge of the wafer to the centre of the wafer. This corresponds to the slightly higher pressure zone near the centre of chamber 55 as described above. The above described nonuniformity was eliminated by attaching a Z plate 46 to the centre portion of the injector plate 48b above the wafer platform 4.

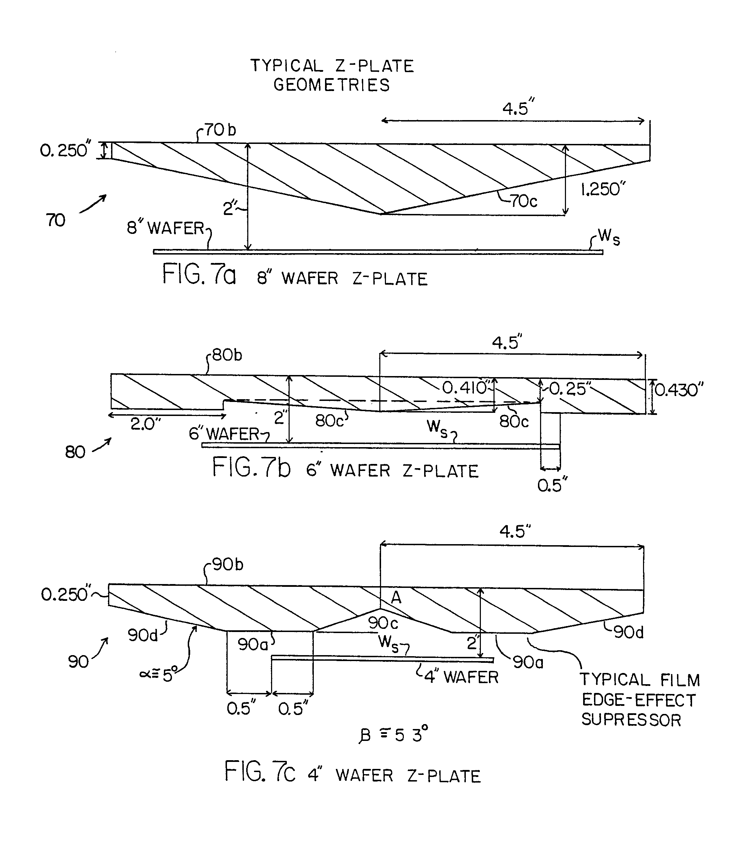

For the gas flow pattern and cylindrical chamber 55 described above, it has been deduced from localized molecular collision frequency theory that relates the surface chemical reactively to localized volume and pressure that the most important variable in controlling the local rate of chemical reaction at the surface of the wafer is the local volume distribution of the reaction chamber above the wafer. This variable may be controlled by controlling the distance between heater platform surfaces 4a and 4c and surface 46a of a specially contoured plate, herein termed a Z plate 46 by appropritely shaping the Z plate. In general, locally decreasing the distance between the surface of the wafer and the surface of the Z plate locally decreases the rate of film deposition from what it would otherwise be, since decreasing the distance decreases the local probability of molecular collision. Similarly, locally increasing this distance locally increases the deposition reate. Figures 7a, 7b and 7c show a cross section of typical Z plate geometries for achieving a uniform deposition profile on wafers of varying diameters.

The Z plates shown in Figures 7a, 7b and 7c were used with a reactor wherein the diameter of inner housing 38 was 13 inches (33.02 cms). The shape of these plates was determined empirically. In a series of experiments the wafers shown in Figure 7a through 7c were located in well 10 of heater platform 4 (which is not shown for simplicity).

Z plate 80, shown in Figure 7b provides excellent uniformity of deposition thicknesses on surface $W_s$ of a wafer W having a six inch (15.24 cms) diameter (the thickness, t, of the deposition does not vary by more than 1% over the entire surface of the wafer). Z plate 80, shown in Figure 7b, is a circular plate having a diameter of 4.5 inches (29.03 cms). Surface 80b of the plate 80 is attached to surface 48b of the injector plate 37. The thickness of the annular region between surface 80b and annular surface 48a is 0.043 inches - (1.09 mm). The width of annular surface 80a is 2.0 inches ( 5.08 cms). Annular surface 80a overlaps the wafer by 0.5 (1.27 cms). The distance between back surface 80b and wafer surface $W_S$ is two inches (5.09 cms). The reduced distance between the surface 80a and the wafer surface $W_S$ - (compared to the distance between wafer surface $W_S$ and surface 80c of Z plate 80b) suppresses the edge effects that would otherwise cause thicker deposition near the outer edge of the wafer. The remaining surface 80c is a shallow, right circular conical surface. As shown in Figure 7b, the apex of this conical surface is 0.010 inches (1.04 cms) from surface 80b and is located opposite the centre of the wafer W. The base of conical surface 80c, indicated by the dashed line in Figure 80c, is 0.25 inches (6.35 mm) from surface 30b. The decreasing distance between wafer surface $W_S$ and surface 80c as one progresses from the base of the cone to the apex of the cone causes the deposition of wafer surface $W_S$ to have uniform thickness. The shorter distance between wafer surface $W_S$ and surface 80c near the centre of the conical surface 80c suppresses the deposition build up near the centre of the wafer which would occur if surface 80c were flat.

Figure 7a shows a configuration of another embodiment of a Z plate 70 which is suitable for pro ducing uniform deposition thickness on a wafer having an eight inch diameter (20.32 cms). Back surface 70b of Z plate 70 is attached to injector plate 48b shown in Figures 1 and 6. Again, Z plate 70 is a circular plate having a diameter of 4.5 inches (11.43 cms). Plate 70 is 0.25 inches (6.35 mm) thick at the edge and becomes thicker as it tapers downward toward the centre of water surface $W_S$. The apex of the cone formed by surface 70c is 0.75 inches (1.91 cms) from the centre of the wafer. The decreasing distance between right circular conical surface 70c and wafer surface $W_S$ as one progresses from the edge of the wafer to the centre of the wafer produces a film having uniform thickness on the surface of the wafer. For the eight inch (20.32 cms) wafer, an edge suppressor region corresponding to annular region 80a in Figure 7b is not necessary as the edge effects are not as pronounced when the edge of the wafer is near the perimeter of reactor chamber 55.

Figure 7c shows a configuration of another embodiment of a Z plate in chamber 55 which is appropriate for producing a deposition having uniform thickness on the surface of the wafer having a four inch (10.16 cms) diameter. Surface 90b of plate 90 is attached to injector plate 48b. Z plate 90 has a radius of 4.5 inches (11.43 cms) and a thickness of 0.25 inches (6.4 mm) at its outer edge. Surface 90d tapers downward to the outer edge of annular surface 90a forming an angle alpha ($\alpha$) of approximately 5° with surface 90a. Note that the apex A of this conical surface 90c is further from the wafer than the base of conical surface 90c. Annular surface 90a is one inch wide (2.54 cms) and overlaps the four inch wafer by one half inch - (1.27 cms). Conical surface 90c forms an angle beta ($\beta$) of approximately 5.3° with annular surface 90a. The purpose of the short distance between annular surface 90a and wafer surface $W_S$ is again to suppress edge effects. For this wafer of smaller diameter, the edge suppressor surface 90a and conical surface 90c provide a Z plate geometry that produces a uniform deposition thickness on the surface of the wafer. As can be seen by the above examples, the Z plate can be configured to achieve a uniform deposition thickness profile over the entire surface of the wafer, the configuration depending on the diameter of the wafer.

As stated above, the shape of the Z plates used to obtain a uniform deposition was determined empirically for silane and oxygen at 400°C at a pressure between 100 and 400 millitorr. In general the configuration of the Z plate required to produce a uniform film thickness is a function of the pressure regime and of the particular chemical reaction employed.

The reactor described above functions at a selected pressure between 0 torr and several hundred atmospheres and at desired temperatures consistent with the materials used to construct the housing. However the appropriate shape of the Z plate required to obtain a uniform film thickness must be determined empirically for pressure regimes other than those described herein.

A Z plate may also be used to control the depth profile of a film deposited on the surface of the wafer in a diffusion tube. Figure 8 shows a cross section of one embodiment of the present invention for a diffusion tube. One or more reactant gases enter a diffusion tube 95 at end A from a gas source or sources (not shown) and exit from the diffusion tube 95 at opposite end B. The solid arrows in Figure 8 indicate the direction of bulk gas flow in tube 95. A plurlity of wafer $W_k$ where $k = 1,...,N$ are held in a wafer cassette 96 typically made of quartz, which rests in the tube 95. A plurality of Z plates $P_k$ where $k = 1,...,N$ are attached to and extend upward from wafer cassette 96, each plate $P_k$ being located between wafer $W_k$ and wafer $W_{k+1}$. Plate $P_N$ extends upward from wafer cassette 96 to the right of wafer $W_N$. The dotted line in Figure 8 indicates the diffusion of gas between the wafers and the Z plates. Again, the exact configuration of the Z plate $P_k$ to produce a uniform depth profile over a surface of wafer $W_k$ and/or $W_{k+1}$ is determined experimentally using the principle that locally decreasing the distance between the wafer surface and the Z plate locally decreases the deposition rate on the wafer surface.

The above embodiments are meant to be exemplary and not limiting. In view of the above disclosure, other modifications will be obvious to one of average skill in the art without departing from the scope of the invention.

For example, while the system described above has two separate annular chambers for injecting two gases, in other embodiments of the invention, the injector system may have a single annular chamber for injecting a single gas and in still other embodiments, the injector system has three separate annular chambers for injecting three gases. One or more of the gases may be inert. For example, polysilicon may be deposited using the embodiment shown in Figures 1 to 7 by using silane for gas A and nitrogen for gas B.

Further, while in the embodiments described above the exhaust vent is located surrounding the heater platform, it may also be located surrounding the circular Z plate. In the preferred embodiment - (as shown) inner housing 38 forms the wall of a right circular cylinder, however housing 38 joining the circular base of the reactor chamber to the circular top of the reactor chamber may also be curved.

Finally, while a single cylindrical chamber is shown in Figure 1, the system design may obviously be scaled up to contain a plurality of cylindrical chambers in one large rectangular housing that attaches to one large rectangular heater to allow a corresponding plurality of wafers to be processed simultaneously.

**Claims**

1. A method of depositing a film of a selected thickness profile onto a wafer, said method comprising the steps of locating the wafer in a chamber, and introducing one or more gasses to the chamber to effect said film deposition, characterised in that the method comprises the preliminary step of creating a region within the chamber adjacent the wafer, the region having a configuration determined in accordance with the desired thickness profile of the film.

2. A method according to claim 1 wherein the method further comprises the steps of locating a plurality of wafers in said chamber and introducing said one or more gases to the chamber to deposit a film of a selected thickness profile onto each wafer, the method also comprising the step of locating a plurality of plates in the chamber, each plate having a surface facing a surface of a respective one of said plurality of wafers, the shape of the region defined between each plate and the respective wafer having a configuration determined in accordance with the desired thickness profile of the film to be deposited on the respective wafer.

3. An apparatus for depositing film of a selected thickness profile on to a wafer, said apparatus comprising means defining a chamber, means for locating said wafer within the chamber with at least one face of the wafer exposed, and means for introducing one or more gases to the chamber to effect film deposition, characterised in that means are provided within the chamber to define a region adjacent the or each exposed face of the wafer, the region having a configuration such that the distance between the exposed face of the wafer and the surface opposed to the exposed face of the wafer which defines said region is not uniform over the whole face of the wafer.

4. An apparatus according to claim 3, wherein, in use, the film is deposited with a non-uniform profile, the profile being controlled at least partly by said configuration.

5. An apparatus according to claim 3 or 4 wherein the means defining said region comprise means defining a right circular conical region.

6. An apparatus according to claim 5 wherein the said conical region extends towards the wafer.

7. An apparatus according to claim 5 wherein the said conical region extends away from the wafer.

8. An apparatus according to any one of claims 3 to 6 wherein the said surface opposed to the exposed face of the wafer comprises an annular region of predetermined configuration, different from the configuration of the rest of the surface, to suppress edge effects.

9. An apparatus according to claim 5, 6 or 7 wherein the means defining the conical region define a substantially flat annular region surrounding the conical region to suppress edge effects.

10. An apparatus according to any one of claims 3 to 9 wherein means are provided to heat said substrate to a selected temperature.

11. An apparatus according to any one of claims 3 to 10 wherein said chamber is a cylindrical chamber, said chamber having a base defining a well which constitutes the means for locating the wafer in the chamber.

12. An apparatus according to claim 11 wherein said base supports said wafer in a substantially vertical orientation.

13. An apparatus according to claim 11 or 12 wherein an annular exhaust vent is provided surrounding said base to exhaust gas from said chamber.

14. An apparatus according to any one of claims 13 to 13 wherein the means for introducing gases to the chamber comprises a plurality of jets, and means to inject one or more gases through the jets into the chamber, each jet being provided with means to deflect gas from the jet towards a peripheral wall of said chamber.

15. An apparatus according to any one of claims 23 to 14 wherein means are provided to hold a plurality of wafers in position within the chamber.

16. An apparatus according to claim 15 wherein means are provided to locate a plurality of plates in said chamber to constitute said region defining means, each plate having a surface facing a surface of a respective one of said plurality of wafers and defining a respective said region therebetween.

17. An apparatus for depositing a film onto a wafer, said apparatus comprising a chamber and means for locating said wafer within the chamber with at least one face of said wafer exposed, said chamber including a first wall opposite said wafer, characterised in that said apparatus further comprises a first plurality of nozzles located near the periphery of said first wall for introducing a first gas into said chamber, said first plurality of nozzles directing said first gas away from the center of said chamber; and first means for deflecting said first gas towards the center of said chamber.

18. An apparatus according to claim 17 wherein said apparatus further comprises a second plurality of nozzles located near the periphery of said first wall for introducing a second gas into said chamber, said second plurality of nozzles directing said second gas away from the center of said chamber; and second means for deflecting said second gas towards the center of said chamber.

19. An apparatus according to claim 17 or 18 further comprising an annular exhaust vent laterally surrounding said wafer, said gas or gases exiting said chamber via said exhaust vent.

FIG. 1

FIG. 2

FIG. 3

FIG.4

FIG. 5

48b-5
48b-6
45a
45
44
44a
44b
45b
40
39
48b-2
48b-1
48b-3
48b-4
48b
48b-8
(~0.015″ DIA)
48b-7

FIG. 6

WN
W₂
W₁
A
P₁ P₂ P_{N-1} P_N
B
96 95

FIG. 8

TYPICAL Z-PLATE
GEOMETRIES

FIG. 7a 8" WAFER Z-PLATE

FIG. 7b 6" WAFER Z-PLATE

FIG. 7c 4" WAFER Z-PLATE